(19) **Europäisches Patentamt**
**European Patent Office**
**Office européen des brevets**

(11) **EP 3 929 640 B1**

(12) **FASCICULE DE BREVET EUROPEEN**

(45) Date de publication et mention
de la délivrance du brevet:
**05.11.2025 Bulletin 2025/45**

(21) Numéro de dépôt: **21180494.3**

(22) Date de dépôt: **20.06.2021**

(51) Classification Internationale des Brevets (IPC):
*G02B 6/12* *(2006.01)*     *G02B 6/122* *(2006.01)*
*G02B 6/42* *(2006.01)*     *G01S 17/00* *(2020.01)*
*G01S 7/48* *(2006.01)*     *H01S 5/10* *(2021.01)*
*H01S 3/00* *(2006.01)*     *G02B 27/09* *(2006.01)*
*G02B 6/124* *(2006.01)*     *G01S 7/481* *(2006.01)*
*H01S 5/0225* *(2021.01)*

(52) Classification Coopérative des Brevets (CPC):
**G02B 6/4206; G01S 7/4814; G02B 6/12004;**
**G02B 6/1228; H01S 5/0225; H01S 5/02251;**
G02B 6/12009; G02B 6/1245; G02B 6/4296;
G02B 2006/12061; G02B 2006/12152;
G02B 2006/12195; H01S 5/1014

(54) **SYSTÈME OPTIQUE COMPORTANT UN DISPOSITIF INTEGRE DE COUPLAGE OPTIQUE ENTRE UNE SOURCE LASER EVASEE ET UN GUIDE D'ONDE**

OPTISCHES SYSTEM MIT EINER INTEGRIERTEN OPTISCHEN KOPPLUNGSVORRICHTUNG ZWISCHEN EINER AUSGEWEITETEN LASERQUELLE UND EINEM WELLENLEITER

OPTICAL SYSTEM INCLUDING AN INTEGRATED OPTICAL COUPLING DEVICE BETWEEN A FLARED LASER SOURCE AND A WAVEGUIDE

(84) Etats contractants désignés:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorité: **24.06.2020 FR 2006616**

(43) Date de publication de la demande:
**29.12.2021 Bulletin 2021/52**

(73) Titulaire: **Commissariat à l'Energie Atomique et**
**aux Energies**
**Alternatives**
**75015 Paris (FR)**

(72) Inventeurs:
• **GUERBER, Sylvain**
**38054 Grenoble Cedex 09 (FR)**
• **FOWLER, Daivid**
**38054 Grenoble Cedex 09 (FR)**

• **SZELAG, Bertrand**
**38054 Grenoble Cedex 09 (FR)**

(74) Mandataire: **Brevalex**
**Tour Trinity**
**1 B Place de la Défense**
**92400 Courbevoie (FR)**

(56) Documents cités:
**FR-A1- 2 821 166**

• **SYLVIE DEL EPINEDELEPINE ET AL: "How to Launch 1 W Into Single-Mode Fiber From a Single 1.48-m Flared Resonator", IEEE JOURNAL OF SELECTED TOPICS IN QUANTUM ELECTRONICS, IEEE SERVICE CENTER, PISCATAWAY, NJ, US, vol. 7, no. 2, 1 March 2001 (2001-03-01), XP011061908, ISSN: 1077-260X**

**Description**

## DOMAINE TECHNIQUE

Le domaine de l'invention est celui des circuits photoniques sur puce, et plus précisément de celui du couplage optique d'une source laser de type évasé avec un guide d'onde d'une puce photonique. L'invention peut trouver une application notamment dans le domaine de la télédétection par laser (LIDAR, pour *Light Detection and Ranging,* en anglais).

## ÉTAT DE LA TECHNIQUE ANTÉRIEURE

Diverses applications, comme celle de la télédétection par laser, requièrent l'utilisation d'une source laser à semiconducteur émettant un signal optique de forte puissance. Une telle source laser peut être une source laser dite évasée comme celle décrite notamment dans l'article de Wenzel et al. intitulé High-brightness diode lasers, C.R. Physique 4 (2003), 649-661.

Une source laser évasée comporte habituellement un guide d'onde actif (situé dans la cavité optique) formé d'une section droite monomode suivie d'une section évasée, laquelle se termine par une surface d'émission de la source laser. La section droite monomode peut être de type ruban (*ridge,* en anglais) de faibles dimensions transversales de manière à former un filtre spatial et forcer le signal optique à être monomode transverse, et la section évasée peut assurer l'amplification du signal optique. La surface d'émission de la source laser peut alors présenter une largeur de l'ordre d'une à plusieurs centaines de microns. De telles sources laser évasées peuvent ainsi émettre un signal optique de forte puissance, par exemple de l'ordre de plusieurs watts.

Cependant, il importe de pouvoir coupler une telle source laser évasée avec un guide d'onde de sortie. Il existe des dispositifs optiques assurant le couplage optique en espace libre entre la source laser évasée et une fibre optique monomode, comme celui décrit dans l'article de Delepine et al. intitulé How to Launch 1 W Into Single-Mode Fiber from a Single 1.48μm Flared Resonator, IEEE Journal on Selected Topics in Quantum Electronics, Vol. 7, No. 2, (2001), 111-123. Ce type de dispositif optique comporte un ensemble de lentilles de collimation et de focalisation, dont le positionnement relatif est particulièrement difficile, et dont les performances de couplage sont fortement sensibles aux erreurs de positionnement relatif.

On souhaite donc pouvoir coupler la source laser évasée avec un guide d'onde de sortie sur une puce photonique. Cependant, le signal optique émis par la source laser évasée présente une répartition spatiale très elliptique de son intensité, sa largeur étant de l'ordre de plusieurs centaines de microns suivant un axe horizontal, alors que les dimensions transversales du mode optique supporté par le guide d'onde de sortie peuvent être de l'ordre du micron seulement, ce qui rend le couplage optique particulièrement difficile à obtenir.

Notons qu'il existe les lentilles planaires à gradient d'indice, réalisées sur une puce photonique, qui peuvent collimater le signal optique incident. Un exemple de telles lentilles planaires, ici une lentille dite de Luneburg, est décrit dans l'article de Kim et al. intitulé Luneburg Lens for Wide-Angle Chip-Scale Optical Beam Steering, Conference on Lasers and Electro-Optics (CLEO), 2019. Cependant, les lentilles planaires à gradient d'indice sont généralement de type à cristaux photoniques, de sorte qu'elles sont formées d'une pluralité de trous de différents diamètres sub-longueur d'onde réalisés dans une couche mince de silicium d'un substrat SOI. Les trous sont agencés pour que l'indice effectif du mode optique présente une variation prédéfinie permettant d'obtenir la fonction de collimation. Or, il apparaît que ces trous formant le cristal photonique de la lentille sont particulièrement complexes à réaliser, et que les imperfections de réalisation impactent fortement les performances d'un tel dispositif optique.

Par ailleurs, le document FR2821166 décrit un dispositif de couplage entre une diode laser multimode et un guide d'onde monomode. Il comporte donc un coupleur d'entrée pour recevoir le faisceau lumineux incident, et un combineur de sortie couplé au guide d'onde. Il comporte également un filtre optique, sous la forme d'une zone de rétrécissement adiabatique, permettant de sélectionner l'un des modes optiques présents dans le faisceau lumineux incident.

## EXPOSÉ DE L'INVENTION

L'invention a pour objectif de remédier au moins en partie aux inconvénients de l'art antérieur, et plus particulièrement de proposer un système optoélectronique comportant un dispositif de couplage optique, sur puce photonique, entre une source laser évasée du système et un guide d'onde de sortie, présentant des performances élevées, en termes de collection du signal optique émis, de transmission du signal optique ainsi collecté, et/ou de focalisation à l'entrée du guide d'onde de sortie.

Pour cela, l'objet de l'invention est un système optoélectronique selon la revendication 1.

La source laser évasée comporte, suivant un axe optique Δ, une section droite monomode, et une section évasée, dans un plan principal, se terminant par une surface d'émission du signal optique. Elle est configurée pour émettre un signal optique dont un front d'onde, dans le plan principal, est circulaire et centré en une position $z_h$ située dans la section évasée sur l'axe optique $\Delta$.

Selon l'invention, le dispositif de couplage comporte, disposés sur la puce photonique :

- un coupleur, destiné à être couplé à la source laser évasée pour collecter et transmettre au moins une partie du signal optique émis, comportant une sortie courbée en arc de cercle dont le centre est destiné à être situé en la position $z_h$ ;
- un combineur, couplé à des guides d'onde intermédiaires pour recevoir les signaux optiques transmis par ces derniers, et les focaliser à une entrée du guide d'onde de sortie, et étant une lentille planaire de focalisation, comportant une entrée et une sortie délimitant une région à propagation libre d'indice de réfraction homogène, l'entrée étant courbée en arc de cercle dont le centre est en une position $z_{gs}$ de la face de sortie où se situe l'entrée du guide d'onde de sortie ;
- un réseau de guides d'onde intermédiaires, couplés à la sortie courbe du coupleur pour recevoir le signal optique collecté et le transmettre jusqu'à l'entrée courbe du combineur, et comportant : une section amont de raccord dans laquelle ils sont raccordés de manière orthogonale à la sortie courbe de coupleur ; une section aval de raccord dans laquelle ils sont raccordés de manière orthogonale à l'entrée courbe de combineur ; une section centrale de correction, située entre les sections amont et aval de raccord, dans laquelle un indice effectif associé aux modes guidés est adapté de sorte que les chemins optiques des guides d'onde intermédiaires entre la sortie courbe du coupleur et l'entrée courbe du combineur sont identiques entre eux.

Certains aspects préférés mais non limitatifs de ce dispositif de couplage sont les suivants.

Les guides d'onde intermédiaires peuvent présenter, dans la section centrale de correction, une variation longitudinale d'au moins une dimension transversale, ladite variation longitudinale étant prédéfinie pour chaque guide d'onde intermédiaire, de sorte que les chemins optiques des guides d'onde intermédiaires sont identiques entre eux.

Chaque guide d'onde intermédiaire peut présenter, dans la section centrale de correction, une variation adiabatique de la largeur, passant d'une première valeur minimale identique pour chaque guide d'onde intermédiaire à une valeur maximale différente d'un guide d'onde intermédiaire à l'autre, pour ensuite diminuer jusqu'à une deuxième valeur minimale identique pour chaque guide d'onde intermédiaire.

Le dispositif de couplage peut comporter des guides d'onde dits additionnels réalisés en un indice de réfraction différent de celui des guides d'onde intermédiaires, s'étendant uniquement dans la section centrale de correction, et agencés chacun en regard et de manière parallèle à un guide d'onde intermédiaire, de manière à autoriser un couplage modal avec le guide d'onde intermédiaire considéré, les guides d'onde additionnels présentant une longueur prédéfinie différente d'un guide d'onde additionnel à l'autre, de sorte que les chemins optiques des guides d'onde intermédiaires sont identiques entre eux.

Le dispositif de couplage peut comporter des déphaseurs thermo-optiques agencés uniquement dans la section centrale de correction pour générer, par l'application d'une température aux guides d'onde intermédiaires, un déphasage prédéfini entre les modes optiques dans les guides d'onde intermédiaires de sorte que les chemins optiques des guides d'onde intermédiaires sont identiques entre eux.

Le coupleur peut être formé d'un réseau de guides d'onde en pointe, chacun étant rectiligne et orienté en direction d'une même position destinée à coïncider avec la position $z_h$, les guides d'onde en pointe étant agencés latéralement de sorte que leurs extrémités aval sont disposées en arc de cercle dont le centre est destiné à être situé en la position $z_h$, formant ainsi la sortie courbe du coupleur.

Le coupleur peut être un coupleur en étoile, comportant une face d'entrée destinée à être orientée de manière orthogonale à l'axe optique $\Delta$, une face de sortie courbe, et une région de propagation libre d'indice de réfraction homogène délimitée par les faces d'entrée et de sortie.

La puce photonique peut comporter un substrat de type silicium sur isolant.

Les puces émettrice et photonique peuvent être assemblées l'une à l'autre par une couche adhésive.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1 est une vue de dessus, schématique et partielle, d'une source laser évasée couplée à un guide d'onde de sortie par un dispositif de couplage selon un mode de réalisation ;

la figure 2A est une vue détaillée d'une partie du dispositif de couplage illustré sur la fig.1, illustrant plus précisément la source laser évasée ainsi que le coupleur du dispositif de couplage ;

la figure 2B est une vue détaillée d'une partie du dispositif de couplage illustré sur la fig.1, illustrant plus précisément les guides d'onde intermédiaires dans la section centrale de correction, où ils présentent une variation longitudinale de la largeur locale ;

la figure 3A est une vue détaillée, en coupe longitudinale et en éclaté, d'une partie d'un dispositif de couplage selon une variante du mode de réalisation illustré sur la fig.1, illustrant plus précisément les guides d'onde intermédiaires dans la section centrale de correction, où ils sont couplés à des guides d'onde additionnels pour former des supermodes ;

la figure 3B est une vue détaillée, en coupe longitudinale et en éclaté, d'une partie d'un dispositif de couplage selon une autre variante du mode de réalisation illustré sur la fig.1, illustrant plus précisément les guides d'onde intermédiaires dans la section centrale de correction, où des déphaseurs thermo-optiques sont adaptés à appliquer une température induisant une variation de l'indice de réfraction du guide d'onde intermédiaire sous-jacent ;

la figure 4 est une vue de dessus, schématique et partielle, d'un dispositif de couplage selon une autre variante du mode de réalisation illustré sur la fig.1, dans laquelle le combineur est un réseau échelle ;

la figure 5 est une vue de dessus, schématique et partielle, d'un dispositif de couplage selon une autre variante du mode de réalisation illustré sur la fig.1, dans laquelle le coupleur est un coupleur en étoile ;

la figure 6A et 6B illustrent, en vue de dessus et en coupe transversale, une partie du dispositif de couplage selon deux autres variantes de réalisation, dans laquelle des portions à changement de phase sont disposées au niveau des guides d'onde intermédiaires dans la section centrale de correction.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

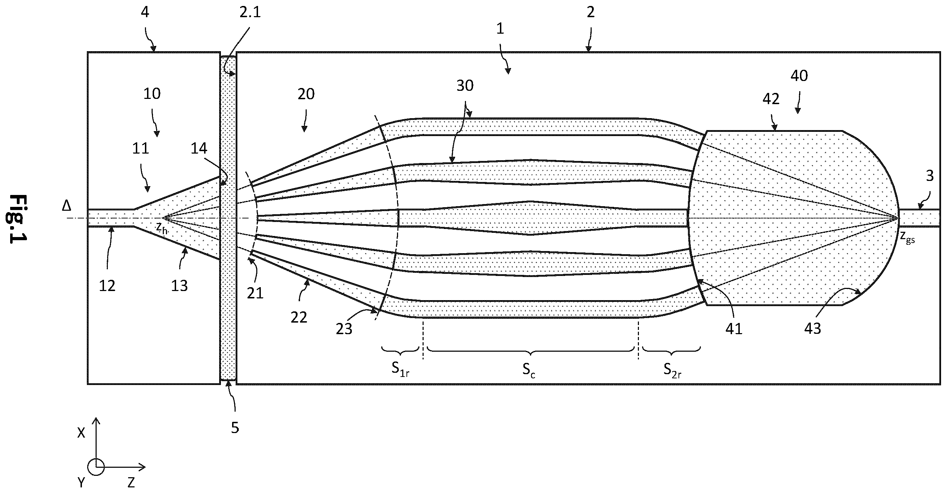

La figure 1 est une vue schématique et partielle d'un dispositif de couplage 1 selon un mode de réalisation, assurant le couplage optique entre une source laser évasée 10 et un guide d'onde de sortie 3 d'une puce photonique 2.

D'une manière générale, le dispositif de couplage 1 comporte, disposés sur la puce photonique 2:

- un coupleur 20 destiné à être couplé à la source laser évasée 10 pour collecter au moins une partie du signal optique émis,
- un réseau de guides d'onde dits intermédiaires couplés au coupleur 20 pour recevoir et transmettre le signal optique collecté, et
- un combineur 40 couplé aux guides d'onde intermédiaires 30 pour focaliser à l'entrée du guide d'onde de sortie 3 les signaux optiques transmis.

On définit ici et pour la suite de la description un repère direct orthonormé XYZ, où le plan XZ est parallèle au plan principal de la puce photonique 2, et où l'axe longitudinal Z est orienté suivant l'axe optique $\Delta$ de la source laser évasée 10. L'axe X est appelé axe horizontal, et l'axe Y est appelé axe vertical. Les termes « amont » et « aval » font référence à un positionnement croissant suivant le sens de propagation du signal optique, ici suivant la direction +Z.

Une source laser évasée 10 est intégrée sur une puce 4 dite émettrice. Elle est adaptée à émettre un signal optique monochromatique pulsé ou continu, de longueur d'onde $\lambda_e$ par exemple égale à 905nm environ, voire à 1550nm. Elle est dite évasée dans le sens où le guide d'onde actif 11 situé dans la cavité optique comporte, suivant un axe optique $\Delta$, une section droite monomode 12 suivie d'une section évasée 13 se terminant par une surface d'émission 14. Aussi, la répartition spatiale dans un plan XY de l'intensité du signal optique émis est elliptique et 'aplatie' : elle présente, en champ proche, une petite dimension suivant l'axe vertical Y, par exemple de l'ordre du micron, et une grande dimension suivant l'axe horizontal X, par exemple de l'ordre de la centaine de microns, avec un rapport de forme (grande dimension sur petite dimension) de l'ordre de 50 à 100, voire davantage. La source laser évasée 10 peut être réalisée de manière identique ou similaire à l'article de Delepine et al. 2001 mentionné précédemment.

La puce émettrice 4 est ici distincte de la puce photonique 2 qui comporte le dispositif de couplage 1 et le guide d'onde de sortie 3. Elle comporte un substrat support sur laquelle repose une couche active comportant des puits quantiques multiples qui s'étendent dans le plan XZ. La couche active peut être encadrée suivant l'axe vertical Y par des couches de confinement. Une couche supérieure structurée recouvre la couche active, dans laquelle un guide d'onde dit actif 11 est formé et s'étend suivant l'axe optique $\Delta$.

Ce guide d'onde actif 11 comporte une section droite monomode 12 de type ruban (*ridge,* en anglais), définie latéralement dans le plan XZ par gravure localisée. Cette section droite monomode 12 présente des dimensions transversales telles qu'elle ne supporte, à la longueur d'onde d'émission $\lambda_e$, qu'un seul mode optique transverse guidé, par exemple le mode transverse fondamental. Par ailleurs, la section droite monomode 12 présente une fonction de filtrage modal dans la mesure où les modes transverses d'ordres supérieurs éventuellement excités dans la section évasée 13 ne peuvent être guidés dans la section droite monomode 12.

Il comporte également une section évasée 13, définie dans le plan XZ de la couche supérieure par dopage localisé. Le mode optique y est alors guidé par le gain d'amplification. La section 13 est dite évasée dans la mesure où elle présente une largeur dans le plan XZ qui augmente de manière ici linéaire à mesure que l'on s'éloigne de la section droite monomode 12. Elle peut présenter un angle d'inclinaison par rapport à l'axe optique $\Delta$ de l'ordre de quelques degrés, par exemple compris entre 4° et 6° environ. La section évasée 13 délimite la surface d'émission 14 de la source laser évasée 10, qui s'étend de manière orthogonale à l'axe optique $\Delta$. La surface d'émission 14 présente alors une largeur $w_{f,max}$, suivant ici l'axe horizontal X, de l'ordre d'une à plusieurs centaines de microns.

Notons qu'une source laser évasée 10 est intrinsèquement astigmate, dans le sens où le plan du waist horizontal (i.e. dans le plan XZ) est situé à une position différente du plan du waist vertical (i.e. dans le plan YZ). De manière connue, le plan du waist d'une source laser, littéralement plan du rayon de col, est situé en une position où le front d'onde considéré (horizontal ou vertical) est plan (rayon de courbure infini). Comme l'indique notamment l'article de Delepine et al. 2001, le plan du waist horizontal est situé dans le guide d'onde actif 11, et plus précisément dans la section évasée 13, à une position $z_h$ distante de la surface d'émission 14 d'une valeur $\delta_h$ non nulle suivant l'axe optique $\Delta$, alors que le plan du waist vertical est situé au niveau de la surface d'émission 14 ($\delta_v=0$). La distance $\delta_h$ (et donc la position $z_h$) peut être déterminée par un analyseur de front d'onde.

Aussi, le signal optique émis présente, dans le plan XZ qui est le plan principal de la puce émettrice 4 et celui de la puce photonique 2, un front d'onde circulaire dont le centre est situé en la position $z_h$. Autrement dit, dans le plan XZ, le signal optique émis par la source laser évasée 10 semble émis à partir de la position $z_h$.

Le dispositif de couplage 1 est dit intégré dans la mesure où il est réalisé sur une puce photonique 2. Il est adapté à assurer le couplage optique de la source laser évasée 10 avec un guide d'onde de sortie 3 situé sur la même puce photonique 2. Aussi, comme mentionné précédemment, la puce photonique 2 comporte, agencés de manière successive suivant l'axe de propagation du signal optique, un coupleur 20 pour collecter au moins une partie du signal optique émis par la source laser évasée 10, un réseau de guides d'onde intermédiaires 30 couplés au coupleur 20 pour transmettre le signal optique collecté jusqu'au combineur 40, le combineur 40 étant couplé aux guides d'onde intermédiaires 30 pour recevoir les signaux optiques transmis et à les focaliser à l'entrée du guide d'onde de sortie 3.

La puce photonique 2, également appelée circuit intégré photonique (PIC, pour *Photonic Integrated Circuit,* en anglais), comporte un substrat support (non représenté) à partir duquel peuvent être réalisés des composants photoniques actifs (modulateurs, diodes...) et passifs (guides d'onde, multiplexeurs ou démultiplexeurs...) couplés optiquement les uns aux autres. Dans le cadre de la photonique sur silicium, le substrat support et les composants photoniques sont réalisés à base de silicium. Le substrat support peut ainsi être de type silicium sur isolant (SOI, pour *Silicon On Insulator,* en anglais). Toutefois, de nombreuses autres plateformes technologiques peuvent être utilisées. Typiquement, l'utilisation de guides d'onde réalisés en silicium pour des applications à 905nm n'est pas recommandé puisque le silicium absorbe à cette fréquence. On pourra donc utiliser par exemple du nitrure de silicium (SiN), du nitrure d'aluminium (AlN), des guides en silice dopée, etc...

La puce photonique 2 est ici distincte de la puce émettrice 4. Elle présente une première face latérale 2.1 située en regard de la surface d'émission 14 de la puce émettrice 4, de sorte que le coupleur 20 puisse collecter au moins une partie du signal optique émis par la source laser évasée 10. La puce photonique 2 et la puce émettrice 4 sont assemblées l'une à l'autre ici par une couche 5 d'un matériau adhésif, tel qu'une colle optique, dont l'indice de réfraction est choisi pour ne pas perturber la propagation du signal optique. L'indice de réfraction peut être identique à celui du matériau de gaine des guides d'onde du dispositif de couplage 1. A titre d'exemple, les guides d'onde 30, le coupleur 20 et le combineur 40, peuvent être réalisés en un nitrure de silicium et la gaine en un oxyde de silicium. De plus, l'espacement entre les deux puces 2, 4 suivant l'axe longitudinal Z est de préférence inférieur à 1$\mu$m de manière à limiter le risque d'introduire une erreur de phase et également de limiter les pertes optiques du coupleur. La couche 5 peut toutefois ne pas être utilisée, et le signal optique émis peut être transmis dans l'air entre les deux puces.

Le dispositif de couplage 1 comporte un coupleur 20 adapté à collecter et à transmettre au moins une partie du signal optique émis par la source laser évasée 10. D'une manière générale, le coupleur 20 comporte une entrée 21 de collection du signal optique incident, et une sortie 23 de transmission du signal optique collecté.

Le coupleur 20 est configuré de sorte que la sortie 23 est courbe en arc de cercle avec un centre situé sensiblement en la position $z_h$. Ainsi, la sortie 23 du coupleur 20 présente une courbure qui coïncide avec la courbure du front d'onde du signal optique émis par la source laser évasée 10 et reçu par le coupleur 20. Ainsi, on optimise l'efficacité de collection du signal optique émis et l'efficacité de transmission, et on évite également d'introduire une erreur de phase dans le signal optique transmis. On peut tenir compte ici de la légère différence entre le front d'onde du signal optique émis par la source 10 et le front d'onde du signal optique reçu par le coupleur 20 du fait de la différence d'indice de réfraction entre le matériau de la couche active de la source 10 et celui du coupleur 20.

Par ailleurs, l'entrée de collection 21 présente des dimensions transversales dans le plan XY ayant, de préférence, un rapport de forme au moins du même ordre de grandeur que celui de la répartition spatiale de l'intensité du signal optique émis. Plus précisément, l'entrée de collection 21 présente une hauteur suivant l'axe vertical Y correspondant à l'épaisseur d'une couche guidante de la couche photonique dans laquelle sont réalisés le coupleur 20 et les guides d'onde 30, par exemple de l'ordre du micron (de quelques dizaines de nanomètres à quelques microns), et une largeur suivant l'axe horizontal X de l'ordre d'une à plusieurs centaines de microns. Ainsi, le coupleur 20 est en mesure de recevoir une partie importante du signal optique émis.

Dans ce mode de réalisation, le coupleur 20 est formé en un réseau de guides d'onde en pointe 22 (*tapers,* en anglais) collectant chacun une partie du signal optique incident. Ces guides d'onde 22 sont en pointe et présente une largeur dans le plan XZ qui augmente de manière monotone, ici linéaire, suivant l'axe Z, de manière adiabatique pour optimiser l'efficacité de couplage.

Les guides d'onde en pointe 22 présentent des dimensions identiques les uns des autres, en termes de longueur $L_{gp}$ et de dimensions transversales $w_{gp}(z)$. Ils sont rectilignes et sont chacun orientés en direction de la position $z_h$ de la source laser évasée 10. Les extrémités amont des guides d'onde en pointe 22, ainsi que les extrémités aval, sont agencées suivant un arc de cercle dont le centre est situé en la position $z_h$. Les extrémités amont des guides d'onde 22 définissent l'entrée de collection 21 du coupleur 20, laquelle est ici courbe en arc de cercle, et les extrémités aval des guides d'onde définissent la sortie de transmission 23 du coupleur 20, laquelle est ici également courbe en arc de cercle.

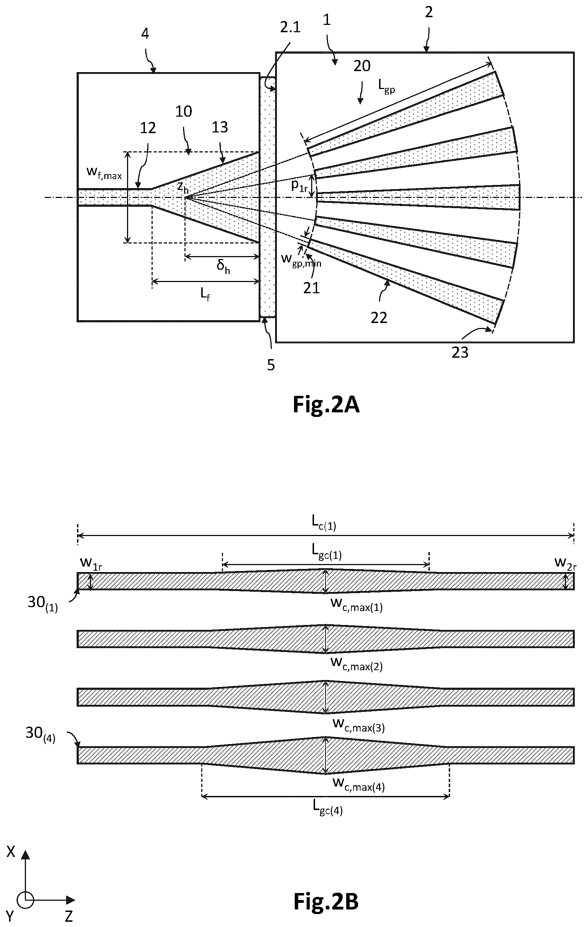

A titre d'exemple, comme l'illustre la figure 2A qui est une vue de dessus, schématique et partielle, illustrant en détail la source laser évasée 10 et le coupleur 20, la source laser évasée 10 peut émettre un signal optique à une longueur d'onde $\lambda_e$ égale à 905nm. La section évasée 13 présente une longueur $L_f$ de 2000$\mu$m et une largeur maximale $w_{f,max}$ de 150$\mu$m au niveau de la surface d'émission 14. La source laser évasée 10 présente ici un astigmatisme tel que la distance $\delta_h$ est égale à 600$\mu$m environ. Le coupleur 20 comporte ici 130 guides d'onde en pointe 22 réalisés dans la couche guidante en un nitrure de silicium d'une épaisseur de 0.3$\mu$m, et agencés à l'entrée 21 du coupleur 20 avec un pas d'espacement suivant l'axe X égal à 1.3$\mu$m environ, permettant ainsi de collecter plus de 90% du signal optique émis. Le rapport de forme de l'entrée de collection du coupleur 20 (dimension horizontale sur la dimension verticale) est donc ici de l'ordre de 500 environ. Chaque guide d'onde en pointe présente une longueur $L_{gp}$ de 100$\mu$m, une largeur minimale $w_{gp,min}$ de 0.1$\mu$m en son extrémité amont (pointe), et une largeur maximale $w_{gp,max}$ de 600nm en son extrémité aval, permettant ainsi d'obtenir une efficacité de transmission de plus de 95% du signal optique collecté.

Ainsi, le coupleur 20 présente une efficacité de collection et de transmission élevée dans la mesure où la sortie 23, et ici également l'entrée 21, est courbe en arc de cercle ayant son centre en la position $z_h$, c'est-à-dire ayant une courbure sensiblement identique à celle du front d'onde du signal optique émis. On évite également d'introduire des erreurs de phase dans les signaux optiques transmis par les différents guides d'onde en pointe 22. Par ailleurs, l'entrée de collection 21 du coupleur 20 présente avantageusement des dimensions transversales (horizontale suivant l'axe X, et verticale suivant l'axe Y) au moins du même ordre de grandeur que celles de la répartition spatiale dans le plan XY de l'intensité du signal optique émis, améliorant ainsi l'efficacité de collection.

Le dispositif de couplage 1 comporte un réseau de plusieurs guides d'onde 30 dits intermédiaires, agencés latéralement ici suivant l'axe horizontal X, qui assurent le couplage entre la sortie 23 du coupleur 20 et l'entrée 41 du combineur 40. Les guides d'onde intermédiaires 30 comportent chacun, suivant l'axe de propagation du signal optique, trois sections, à savoir :

- une section amont de raccord $S_{1r}$, dans laquelle l'extrémité amont des guides d'onde intermédiaires 30 est couplée à la sortie 23 courbe du coupleur 20 ;
- une section centrale $S_c$ de correction de phase, dans laquelle les indices effectifs des modes guidés sont adaptés de sorte que les chemins optiques des guides d'onde intermédiaires 30 sont identiques entre eux ; et
- une section aval de raccord $S_{2r}$, dans laquelle l'extrémité aval des guides d'onde intermédiaires 30 est couplée à l'entrée 41 courbe du combineur 40.

Comme détaillé par la suite, dans la mesure où le combineur 40 est une lentille planaire de focalisation à région de propagation en espace libre (FPR pour *Free Propagation Region,* en anglais), il présente une face d'entrée 41 dont la courbure en arc de cercle permet la focalisation des signaux optiques incidents (transmis par les guides d'onde intermédiaires 30) en un point $z_{gs}$ de sa face de sortie 43. Autrement dit, la position $z_{gs}$ est situé sensiblement au point focal de la lentille de focalisation qu'est le combineur 40.

Ceci implique que les signaux optiques transmis par les guides d'onde intermédiaires 30 présentent, à la face d'entrée 41 du combineur 40, un front d'onde en arc de cercle qui coïncide avec le rayon de courbure de la face d'entrée 41 du combineur 40, c'est-à-dire dont le centre est situé en la position $z_{gs}$ de la face de sortie 43. Pour cela, les guides d'onde intermédiaires 30 présentent, entre les sections amont et aval de raccord, une section centrale de correction $S_c$ adaptée à corriger le front de phase des signaux optiques transmis par le coupleur 20 pour qu'il présente, à la face d'entrée 41 du combineur 40, une courbure sensiblement identique à celle de la face d'entrée 41 du combineur 40. Ainsi, le combineur 40 présente une efficacité élevée de focalisation des signaux optiques incidents à l'entrée du guide d'onde de sortie 3.

Dans la section amont de raccord $S_{1r}$, les guides d'onde intermédiaires 30 sont raccordés en leur extrémité amont de manière orthogonale à la sortie 23 courbe du coupleur 20. Ils présentent une portion courbée dans le plan XZ pour se raccorder à la portion rectiligne des guides d'onde intermédiaires 30 dans la section centrale de correction $S_c$. De préférence, dans la section amont de raccord $S_{1r}$, les guides d'onde intermédiaires 30 présentent des dimensions transversales, en particulier une largeur $w_{1r(i)}$, identiques les uns les autres, et une longueur $L_{1r(i)}$ qui peut varier d'un guide d'onde intermédiaire 30 à l'autre. On note i l'indice du rang du guide d'onde intermédiaire considéré 30, i allant de 1 à N, N étant supérieur à 1 et par exemple égal à une centaine environ, par exemple à 130.

Dans la section aval de raccord $S_{2r}$, les guides d'onde intermédiaires 30 sont raccordés en leur extrémité aval de manière orthogonale à la face d'entrée 41 courbe du combineur 40. Ils présentent une portion courbée dans le plan XZ pour pouvoir se raccorder à la portion rectiligne des guides d'onde intermédiaires 30 dans la section centrale de correction $S_c$. De préférence, dans la section aval de raccord $S_{2r}$, les guides d'onde intermédiaires 30 présentent des dimensions transversales, en particulier une largeur $w_{2r(i)}$, identiques les uns les autres, et présentent une longueur $L_{2r(i)}$ qui peut varier d'un guide d'onde intermédiaire 30 à l'autre.

Dans la section centrale de correction $S_c$, les guides d'onde intermédiaires 30 s'étendent de manière rectiligne et sont parallèles entre eux. L'indice effectif des modes guidés, dans cette section centrale $S_c$, est localement adapté de sorte que les chemins optiques des guides d'onde intermédiaires 30 sont identiques entre eux. Ils présentent une longueur $L_{c(i)}$ de préférence identique d'un guide d'onde intermédiaire 30 à l'autre. Dans cette section centrale $S_c$, les guides d'onde intermédiaires 30 présentent une modification locale de l'indice effectif $n_{eff,c(i)}$ du mode guidé de sorte que les chemins optiques entre les extrémités amont et aval des guides d'onde intermédiaires 30 soient identiques d'un guide d'onde intermédiaire 30 à l'autre.

D'une manière générale, l'indice effectif $n_{eff}$ associé à un mode optique supporté par un guide d'onde est défini comme le produit de la constante de propagation $\beta$ et de $\lambda/2\pi$. La constante de propagation $\beta$ dépend de la longueur d'onde $\lambda$ du mode optique, ainsi que des propriétés du guide d'onde (indice de réfraction et dimensions transversales). L'indice effectif du mode optique correspond, d'une certaine manière, à l'indice de réfraction du guide d'onde 'vu' par le mode optique. Il est habituellement compris entre l'indice du cœur et l'indice de la gaine du guide d'onde.

Par ailleurs, d'une manière générale, le chemin optique d'un guide d'onde est égal au produit de sa longueur physique L avec l'indice effectif $n_{eff}$ du mode guidé. Ici, un guide d'onde intermédiaire de rang i présente une longueur $L_{1r(i)}$ et une largeur $w_{1r(i)}$ dans la section amont, une longueur $L_{c(i)}$ et une largeur $w_{c(i)}$ dans la section centrale $S_c$, et une longueur $L_{2r(i)}$ et une largeur $w_{2r(i)}$ dans la section aval. Le mode guidé dans un guide d'onde intermédiaire 30 de rang i présente un indice effectif noté $n_{eff,1r(i)}$ dans la section amont, $n_{eff,c(i)}$ dans la section centrale $S_c$, et $n_{eff,2r(i)}$ dans la section aval. Le chemin optique d'un guide d'onde intermédiaire est défini entre son extrémité amont raccordée à la sortie 23 courbe du coupleur 20, et son extrémité aval raccordée à l'entrée 41 courbe du combineur 40.

Ainsi, d'une manière générale, l'indice effectif des modes guidés dans les guides d'onde intermédiaires 30 est adapté dans la section centrale de correction $S_c$, de sorte que l'équation suivante soit vérifiée pour tous les guides d'onde intermédiaires 30 :

[Math 1]

$$\forall i, n_{eff,1r(i)}\big(w_{1r(i)}\big) \times L_{1r(i)} + \int_{0}^{L_{c(i)}} n_{eff,c(i)}\big(w_{c(i)}\big)dL + n_{eff,2r(i)}\big(w_{2r(i)}\big) \times L_{2r(i)} = A$$

Où A est une constante non nulle identique pour tous les guides d'onde intermédiaires 30.

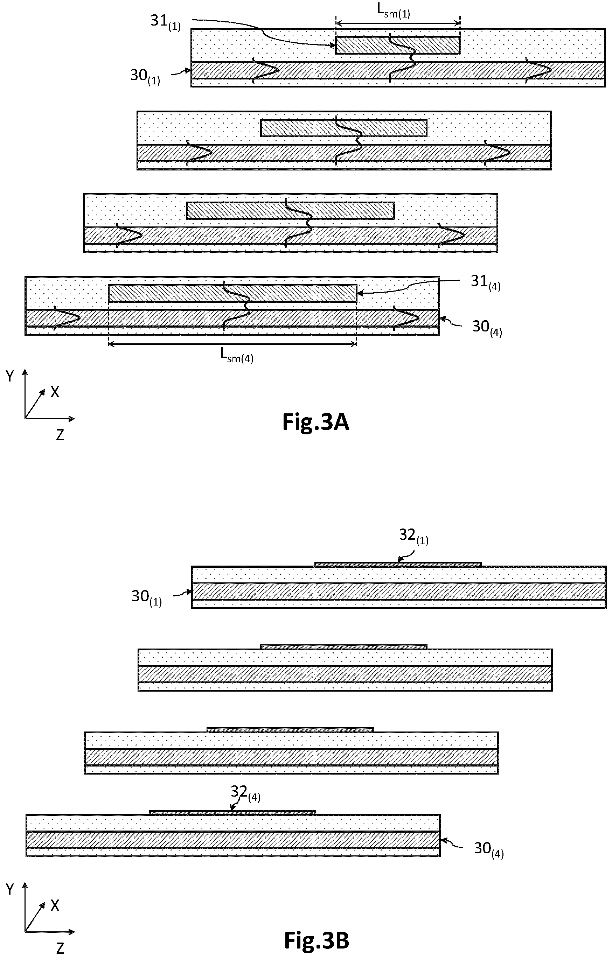

Plusieurs possibilités peuvent être mises en œuvre pour rendre identiques les chemins optiques des guides d'onde intermédiaires 30. Une possibilité (illustrée sur la fig.1 et 2B) consiste à modifier les dimensions transversales des guides d'onde intermédiaires 30 dans la section centrale de correction $S_c$, sur une partie $L_{gc(i)}$ de la longueur $L_{c(i)}$, de manière à corriger l'indice effectif $n_{eff,c(i)}$ du mode guidé dans chacun des guides d'onde intermédiaires 30. Une autre possibilité (illustrée sur la fig.3A) consiste à effectuer un couplage modal entre chaque guide d'onde intermédiaire 30 et un guide d'onde additionnel 31 situé en regard de ce dernier suivant l'axe vertical Y et présentant un indice de réfraction différent de celui du guide d'onde intermédiaire 30 sous-jacent, de manière à obtenir localement un supermode sur une longueur donnée $L_{sm(i)}$. Une autre possibilité (illustrée sur la fig.3B) consiste à contrôler l'indice effectif du mode guidé dans chaque guide d'onde intermédiaire 30 de manière active, au moyen de déphaseurs thermo-optiques 32 additionnels (chaufferettes).

La figure 2B est une vue de dessus, schématique et partielle, de plusieurs guides d'onde intermédiaires 30 au niveau de la section centrale de correction $S_c$. Dans cet exemple, l'épaisseur des guides d'onde intermédiaires 30 reste constante et identique d'un guide d'onde intermédiaire 30 à l'autre.

En-dehors de la section centrale de correction $S_c$, les guides d'onde intermédiaires 30 présentent une largeur $w_{1r(i)}$ et $w_{2r(i)}$ constante et identique d'un guide d'onde intermédiaire 30 à l'autre. Les largeurs $w_{1r(i)}$ et $w_{2r(i)}$ peuvent être égales entre elles.

Dans la section centrale de correction $S_c$, les guides d'onde intermédiaires 30 présentent une variation longitudinale de largeur $w_{c(j)}(z)$ sur au moins une partie $L_{gc(i)}$ de la longueur $L_c$ de la section centrale $S_c$. Dans cet exemple, la variation longitudinale de largeur est monotone, ici linéaire, mais des variations non monotones sont possibles. Ainsi, les guides d'onde intermédiaires 30 présentent une largeur maximale $w_{c,max(i)}$, différente d'un guide d'onde intermédiaire 30 à l'autre, sur une longueur $L_{gc(i)}$ qui peut être identique ou non d'un guide d'onde intermédiaire à l'autre, de sorte que les chemins optiques des guides d'onde intermédiaires 30 soient identiques sur toute leur longueur.

Dans cet exemple, les guides d'onde intermédiaires 30 présentent une variation longitudinale linéaire de la largeur locale $w_{c(j)}(z)$, passant de la valeur initiale $w_{1r}$ à la valeur maximale $w_{c,max(i)}$, pour ensuite diminuer jusqu'à la valeur finale $w_{2r}$. La demi-longueur $L_{gc(i)}/2$ est choisie de sorte que la variation longitudinale de largeur soit adiabatique, c'est-à-dire avec des pertes optiques minimales, voire nulles. Elle peut être égale, à titre d'exemple, à $25\,\mu m$ ou à $50\,\mu m$ environ.

Les largeurs maximales $w_{c,max(i)}$ sont différentes d'un guide d'onde intermédiaire 30 à l'autre, de manière à induire une variation de l'indice effectif $n_{eff,c(i)}$ du mode guidé pour chaque guide d'onde intermédiaire qui se traduise par des chemins optiques identiques pour tous les guides d'onde intermédiaires 30. Ainsi, le front d'onde des signaux optiques transmis présente, à la face d'entrée 41 du combineur 40, une courbure sensiblement identique à celle de la face d'entrée. On limite ou écarte toute dégradation de l'information de phase associée aux modes guidés, ce qui permet d'optimiser l'efficacité de focalisation du combineur 40 à l'entrée du guide d'onde de sortie 3.

La figure 3A est une vue en coupe longitudinale, schématique et partielle, de plusieurs guides d'onde intermédiaires 30 adjacents d'un dispositif de couplage 1 selon une variante du mode de réalisation illustré sur la fig.1, dans laquelle les guides d'onde intermédiaires 30 sont chacun couplés, dans la section centrale de correction $S_c$, à des guides d'onde additionnels 31. Les guides d'onde sont illustrés en vue éclatée.

Dans cette variante, des guides d'onde additionnels 31 sont disposés au regard des guides d'onde intermédiaires 30 suivant l'axe Y de manière à autoriser un couplage modal entre les deux guides d'onde superposés. Les guides d'onde additionnels 31 présentent un indice de réfraction différent de celui des guides d'onde intermédiaires 30, et de préférence supérieur à celui-ci. De préférence, les guides d'onde intermédiaires 30 présentent des dimensions transversales, en particulier la largeur $w_c$, qui restent constantes sur toute leur longueur $L_c$. De préférence également, les guides d'onde supérieurs présentent également des dimensions transversales (épaisseur et largeur) qui restent constantes sur toute leur longueur. Une gaine, par exemple réalisée en un oxyde de silicium, entoure les guides d'onde superposés.

Ainsi, le mode guidé circulant dans un guide d'onde intermédiaire 30 s'étend spatialement à la fois dans le guide d'onde intermédiaire considéré et dans le guide d'onde supérieur, formant alors un supermode. On parle alors de couplage modal. Plus précisément, la composante du champ électrique du supermode présente une distribution spatiale qui recouvre le guide d'onde intermédiaire 30 ainsi que le guide d'onde supérieur 31. Le couplage modal est assuré par un espacement vertical adapté des guides d'onde supérieurs vis-à-vis des guides d'onde intermédiaires 30, égal par exemple à quelques dizaines à centaines de nanomètres.

Ainsi, par le couplage modal entre les deux guides d'onde superposés 30, 31, le mode guidé présente un indice effectif qui est différent dans la section centrale de correction $S_c$ (dû au couplage modal) de celui hors de la section centrale de correction $S_c$. La différence de longueur $L_{sm(i)}$ entre les guides d'onde supérieurs dans la section centrale de correction $S_c$ induit une variation de l'indice effectif $n_{eff,c(i)}$ du mode guidé pour chacun des guides d'onde intermédiaires 30. Ainsi, comme l'illustre la fig.3A, la longueur $L_{sm(1)}$ du guide d'onde supérieur 31 associé au guide d'onde intermédiaire 30 de rang 1 présente une valeur inférieure à celle de $L_{sm(2)}$, qui est elle-même inférieure à $L_{sm(3)}$. Ainsi, le mode guidé circulant dans le guide d'onde intermédiaire 30 de rang 3 présente un chemin optique égal à celui du guide d'onde intermédiaire de rang 2, et à celui du guide d'onde intermédiaire 30 de rang 1. Ainsi, la longueur $L_{sm(i)}$ des guides d'onde supérieurs est prédéfinie pour chaque guide d'onde intermédiaire 30 de sorte que les chemins optiques des guides d'onde intermédiaires 30 sont identiques d'une guide d'onde intermédiaire 30 à l'autre.

La figure 3B est une vue en coupe longitudinale, schématique et partielle, de plusieurs guides d'onde intermédiaires 30 adjacents d'un dispositif de couplage 1 selon une autre variante du mode de réalisation illustré sur la fig.1, dans laquelle les guides d'onde intermédiaires 30 sont chacun associés, dans la section centrale de correction $S_c$, à un déphaseur thermo-optique 32. Les guides d'onde 30 sont illustrés en vue éclatée. Cette variante de réalisation peut être combinée avec les autres variantes et modes de réalisation présentés ici.

Ici, la variation de l'indice effectif du mode guidé pour chacun des guides d'onde intermédiaires 30 est assurée de manière active au moyen de plusieurs déphaseurs additionnels 32, de préférence thermo-optiques pour limiter les pertes optiques, disposés chacun en regard suivant l'axe Y d'un guide d'onde intermédiaire, dans la section centrale de correction $S_c$. Comme dans l'exemple de la fig.3A, les guides d'onde intermédiaires 30 présentent de préférence des dimensions transversales (épaisseur et largeur) qui restent constantes sur toute leur longueur.

La valeur de la température appliquée par chaque déphaseur thermo-optique 32 est prédéterminée en fonction de la variation d'indice effectif à obtenir dans chacun des guides d'onde intermédiaires 30, de manière à égaliser les chemins optiques des guides d'onde intermédiaire. Ainsi, on limite ou évite toute dégradation de l'information de phase portée par les modes guidés dans les guides d'onde intermédiaires 30, de sorte que le front d'onde des signaux optiques à la face d'entrée 41 présente la même courbure que celle-ci, optimisant ainsi l'efficacité de focalisation du combineur 40.

Dans cette variante, on peut ainsi tenir compte et compenser de manière dynamique les éventuelles erreurs de phase. Ces erreurs de phase peuvent provenir d'une dégradation dans le temps de certains éléments de la source laser évasée 10 et/ou du dispositif de couplage 1, de non-uniformités ou tolérances non nulles lors de procédé de fabrication, de l'impact de l'environnement du système optoélectronique, etc. Cette variante est d'autant plus intéressante que la position $z_h$, à partir de laquelle est « vue » l'émission du signal optique dans le plan horizontal XZ, peut être modifiée en fonction notamment de la puissance du signal optique émis ou de la température de la source laser évasée 10.

Un module de commande (non représenté) peut être connecté aux déphaseurs thermo-optiques 32. En fonction des signaux électriques de commande envoyés par le module de commande aux déphaseurs thermo-optiques 32, ceux-ci peuvent induire un déphasage $\Delta\varphi$ défini pour ainsi corriger les éventuelles erreurs de phase et donc obtenir le front d'onde souhaité à la face d'entrée du combineur 40 qui optimise l'efficacité de focalisation. Un photodétecteur (non représenté) peut être couplé au guide d'onde de sortie 3 et ainsi mesurer l'intensité du signal optique circulant dans le guide d'onde de sortie 3, et transmettre au module de commande la valeur mesurée. En fonction de la valeur d'intensité mesurée par le photodétecteur, le module de commande peut, sur la base de cette valeur d'intensité mesurée, déterminer une valeur de déphasage $\Delta\varphi$ à appliquer par les déphaseurs thermo-optiques 32 aux signaux optiques circulant dans les guides d'onde intermédiaires 30, de manière à corriger les éventuelles erreurs de phase et ainsi améliorer l'efficacité de focalisation.

Le dispositif de couplage 1 comporte enfin un combineur 40 adapté à recevoir les signaux optiques transmis par les guides d'onde intermédiaires 30 et à les focaliser à l'entrée du guide d'onde de sortie 3. Le combineur 40 est une lentille planaire de focalisation qui est adaptée à focaliser en la position $z_{gs}$ de sa face de sortie 43 les signaux optiques incidents sur sa face d'entrée 41. Dans cet exemple, l'axe optique du combineur 40 coïncide avec l'axe longitudinal Z, mais en variante cela peut ne pas être le cas.

Pour cela, le combineur 40 comporte une face d'entrée 41, une face de sortie 43, et une région 42 de propagation libre (FPR) située entre les faces d'entrée 41 et de sortie 43. La face d'entrée 41 est courbe en arc de cercle ayant son centre en la position $z_{gs}$. Par ailleurs, le combineur 40 est une lentille dite planaire dans la mesure où la région FPR 42 s'étend dans le plan XZ de la puce photonique 2.

Dans cette région FPR 42, le champ optique est confiné suivant l'axe vertical Y, mais le signal optique peut se propager librement dans le plan XZ. La région FPR 42 est définie par un milieu d'indice de réfraction homogène dans le plan XZ, à la différence d'une lentille à gradient d'indice comme celle mentionnée précédemment en référence à l'article de Kim et al. 2019. Autrement dit, la région FPR présente un indice de réfraction identique en tout point de cette région dans le plan XY et suivant l'axe Y. Un tel combineur 40 de type lentille planaire de focalisation à région FPR, à la différence d'une lentille à gradient d'indice, est plus simple à réaliser et permet de limiter l'impact des tolérances de fabrication sur ses performances.

Un tel combineur 40 est également appelé coupleur en étoile (*star coupler,* en anglais). Il assure la focalisation en la position $z_{gs}$ des signaux optiques incidents. Autrement dit, les signaux optiques incidents se propagent dans la région FPR 42 et convergent vers la position $z_{gs}$ où débouche le guide d'onde de sortie 3. Dans la mesure où les signaux optiques incidents au niveau de la face d'entrée 41 présentent un front d'onde ayant sensiblement la même courbure que celle de la face d'entrée 41, grâce à la section centrale de correction $S_c$ des guides d'onde intermédiaires 30, l'efficacité de focalisation est optimale. Notons que le combineur 40 peut être un coupleur en étoile tel que représenté sur la fig.1, ou être un réseau échelle qui est un cas particulier du coupleur en étoile.

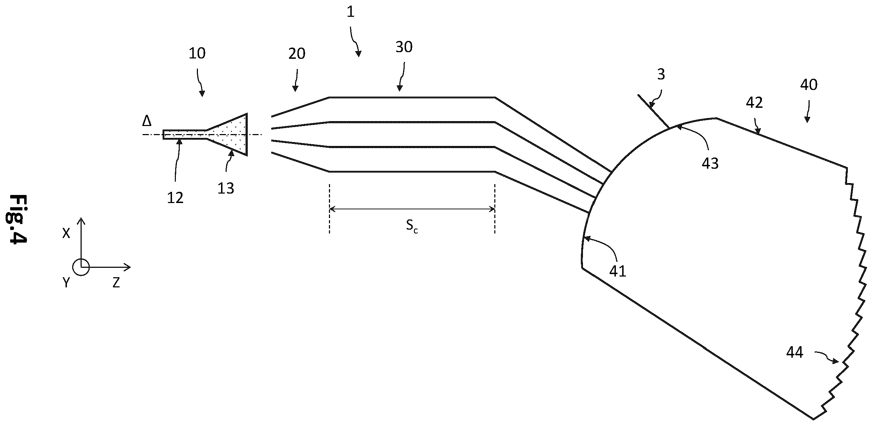

A ce titre, la figure 4 est une vue de dessus, schématique et partielle, d'un dispositif de couplage 1 selon une autre variante du premier mode de réalisation, dans laquelle le combineur 40 est un réseau échelle. La face d'entrée 41 et la face de sortie 43 sont des zones d'une même face courbe située du côté des guides d'onde intermédiaires 30. Une face réflectrice 44 opposée aux zones d'entrée et de sortie délimite avec celles-ci la région FPR 42 à indice de réfraction homogène. La face réflectrice 44 comporte un réseau de réflecteurs élémentaires réfléchissant en direction de la position focale $z_{gs}$ de la face de sortie 43 au niveau de laquelle débouche le guide d'onde de sortie 3.

Ainsi, le dispositif de couplage 1 est en mesure de collecter une partie importante du signal optique émis par la source laser évasée 10, et à le transmettre efficacement dans un guide d'onde de sortie 3 de préférence monomode. Le dispositif de couplage 1 est réalisé sur une puce photonique 2, ce qui permet de réduire la complexité de positionnement relatif de ses différents éléments optiques, à la différence des dispositifs de couplage en espace libre comme dans l'article de Delepine et al. 2001 mentionné précédemment.

Par ailleurs, le dispositif de couplage 1 présente une efficacité de collection élevée du signal optique émis par la source laser évasée 10, dans la mesure où le coupleur 20 présente d'une part une sortie 23 courbée en arc de cercle coïncidant avec la courbure du front d'onde du signal optique émis, et d'autre part une entrée 21 dont les dimensions transversales, horizontale et verticale, sont naturellement adaptées à celles de la répartition spatiale elliptique et aplatie de l'intensité du signal optique émis.

Le dispositif de couplage 1 présente également une efficacité de focalisation élevée à l'entrée du guide d'onde de sortie 3, d'une part par l'utilisation d'un combineur 40 de type coupleur en étoile dont la face d'entrée 41 est courbée pour focaliser les signaux optiques incidents à l'entrée du guide d'onde de sortie 3, et d'autre part par l'égalisation des chemins optiques des guides d'onde intermédiaires 30 via la section centrale de correction $S_c$ du front d'onde des signaux optiques transmis.

Par ailleurs, le dispositif de couplage 1 autorise d'adapter de manière dynamique le déphasage appliqué aux signaux optiques transmis dans les guides d'onde intermédiaires 30, comme décrit précédemment en référence à la fig.3B.

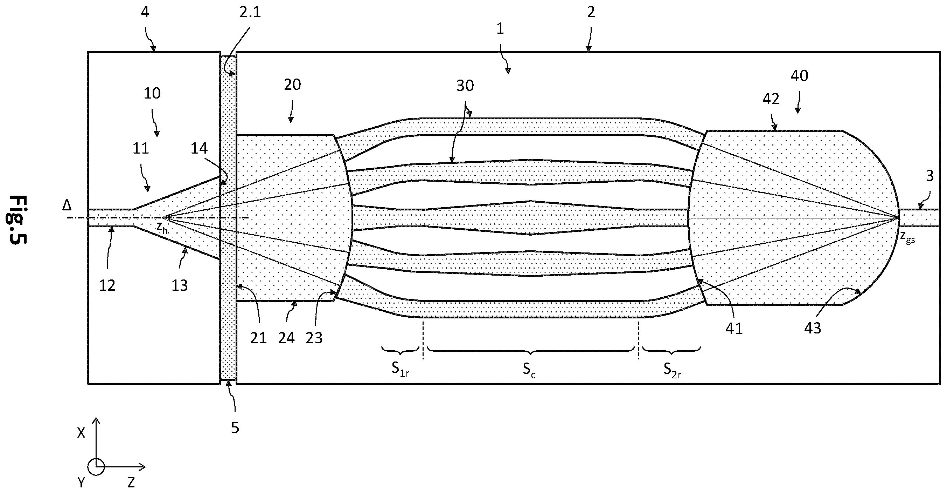

La figure 5 est une vue de dessus, schématique et partielle, d'un dispositif de couplage 1 selon une autre variante du mode de réalisation illustré sur la fig.1, dans laquelle le coupleur 20 est un coupleur en étoile.

Ainsi, le coupleur 20 comporte une face d'entrée 21, ici orthogonale à l'axe optique Δ et située en regard de la source laser évasée 10, une face de sortie 23 présentant une courbure en arc de cercle dont le centre est positionné en la position $z_h$ de la source laser évasée 10, et une région FPR 24 délimitée par les faces d'entrée 21 et de sortie 24. Le coupleur 20 selon cette variante présente l'avantage de s'affranchir de l'impact sur l'efficacité de collection qu'a la valeur minimale $w_{1r,min}$ de la largeur des guides d'onde en pointe 22 présentés précédemment sur la fig.2A.

Les guides d'onde intermédiaires 30, dans la section amont de raccord $S_{1r}$, présentent une largeur $w_{1r}$ qui diminue d'une valeur $w_{1r,max}$ à partir de la face de sortie 23 du coupleur 20, de préférence de manière adiabatique, jusqu'à présenter une valeur minimale $w_{1r,min}$ à l'entrée de la section centrale de correction $S_c$. A titre d'exemple, la valeur $w_{1r,max}$ peut être égale à 2 ou 3 fois la valeur minimale $w_{1r,min}$. Ainsi, les guides d'onde intermédiaires 30 collectent une partie importante du signal optique reçu par le coupleur 20, ce qui permet, à largeur de collection constante, de réduire le nombre N de guides d'onde intermédiaires 30.

Des modes de réalisation particuliers viennent d'être décrits. Différentes variantes et modifications sont possibles sans sortir du cadre de l'invention.

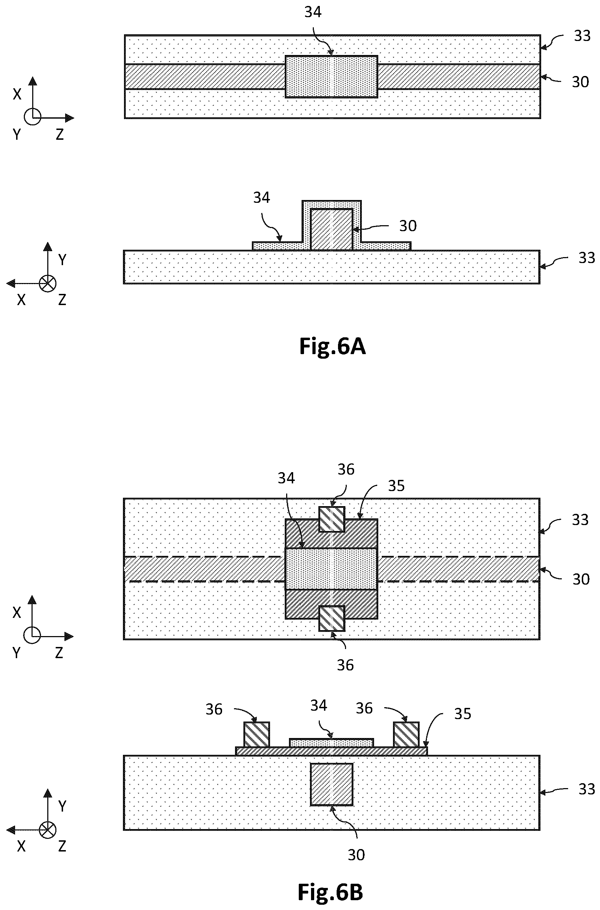

Les figures 6A et 6B sont des vues, schématiques et partielles, de l'un des guides d'onde intermédiaires 30 au niveau de la section centrale de correction ($S_c$), selon deux autres variantes de réalisation de l'émetteur optoélectronique. Ici, la variation de l'indice effectif du mode guidé pour chacun des guides d'onde intermédiaires 30 est assurée au moyen d'un matériau à changement de phase qui participe à former la gaine du guide d'onde 30. Le matériau à changement de phase peut être choisi notamment parmi les chalcogénures, en particulier de type GST, c'est-à-dire formés à base de germanium Ge, d'antimoine Sb, et de tellure Te. On peut se référer au document de Abdollahramezani et al. intitulé Tunable nanophotonics enabled by chalcogenide phase-change materials, Nanophotonics 2020, 9(5), 1189-1241. Les portions 34 de matériaux à changement de phase appliquent un déphasage relatif, de manière statique ou dynamique, entre les modes guidés dans les guides d'onde 30 prédéfini pour chacun d'entre eux de sorte que les chemins optiques des guides d'onde 30 sont identiques entre eux.

La fig.6A illustre, en vue de dessus et en coupe transversale, un premier exemple dans laquelle le matériau à changement de phase présente une phase cristalline prédéfinie lors du procédé de fabrication de dispositif de couplage. Ici, le guide d'onde 30 repose sur un substrat 33 qui participe à former la gaine. Une portion 34 de matériau de changement de phase en couche mince a été déposée sur et autour du guide d'onde 30, et s'étend le long de celui-ci sur une longueur comprise, par exemple, entre 1μm et 100μm. Elle présente ici une épaisseur uniforme, par exemple comprise entre 5nm et 100nm. La phase cristalline du matériau à changement de phase a été définie lors du procédé de fabrication, par exemple au moyen d'impulsions laser. L'indice effectif du mode guidé dépend donc de l'indice de réfraction du matériau à changement de phase (qui dépend de sa phase cristalline).

La fig.6B illustre, en vue de dessus et en coupe transversale, un deuxième exemple dans laquelle le matériau à changement de phase présente une phase cristalline qui peut être modifiée de manière dynamique (ou statique) lors du fonctionnement du dispositif de couplage. Ici, le guide d'onde 30 est enterré dans le substrat 33 qui participe à former la gaine. Une chaufferette 35 est disposée à la surface du substrat 33, au-dessus du guide d'onde 30 et s'étend de part et d'autre de celui-ci suivant l'axe X. Une portion 34 de matériau de changement de phase s'étend sur la chaufferette 35 et au-dessus du guide d'onde 30, sur une longueur comprise, par exemple, entre 1μm et 100μm. Elle présente ici une épaisseur uniforme, par exemple comprise entre 5nm et 100nm. Deux électrodes 36 sont au contact de la chaufferette 35. Ainsi, l'application d'une tension électrique entre les électrodes 36 provoque un échauffement de la chaufferette 34, qui induit une variation de la phase cristalline du matériau à changement de phase. L'indice effectif du mode guidé est alors modifié en conséquence.

**Revendications**

1. Système optoélectronique, comportant :

  ◦ une puce émettrice (4) comportant une source laser évasée (10) comportant, suivant un axe optique Δ, une section droite monomode (12), et une section évasée (13) dans un plan principal et se terminant par une surface d'émission (14) du signal optique, et configurée pour émettre un signal optique dont un front d'onde, dans le plan parallèle, est circulaire et centré en une position $z_h$ située dans la section évasée (13) sur l'axe optique Δ ;
  ◦ une puce photonique (2) comportant un dispositif de couplage (1) adapté à assurer le couplage optique entre une source laser évasée (10), et un guide d'onde de sortie (3) sur la puce photonique (2),
  ◦ la source laser évasée (10) comportant, suivant un axe optique Δ, une section droite monomode (12), et une section évasée (13), dans un plan principal, se terminant par une surface d'émission (14) du signal optique, et étant configurée pour émettre un signal optique dont un front d'onde, dans le plan principal, est circulaire et centré en une position $z_h$ située dans la section évasée (13) sur l'axe optique Δ ;
  ◦ le dispositif de couplage (1) comportant, disposés sur la puce photonique (2), un coupleur (20) couplé à la source laser évasée (10) pour collecter et transmettre au moins une partie du signal optique émis, et un combineur (40),
  ◦ le système optoélectronique étant en outre défini en ce que :

    ◦ le coupleur (20) comporte une sortie (23) courbée en arc de cercle dont le centre est situé en la position $z_h$ ;
    ◦ le combineur (40)

      • est couplé à un réseau de guides d'onde intermédiaires (30) pour recevoir les signaux optiques transmis par ces derniers, et les focaliser à une entrée du guide d'onde de sortie (3) ; et
      • est une lentille planaire de focalisation, comportant une entrée (41) et une sortie (43) délimitant une région (42) à propagation libre d'indice de réfraction homogène, l'entrée (41) étant courbée en arc de cercle dont le centre est en une position $z_{gs}$ de la face de sortie (43) où se situe l'entrée du guide d'onde de sortie (3) ;

    ◦ le réseau de guides d'onde intermédiaires (30)

      • est couplé à la sortie (23) courbe du coupleur (20) pour recevoir le signal optique collecté et le transmettre jusqu'à l'entrée (41) courbe du combineur (40) ; et
      • comporte :

        - une section amont de raccord ($S_{1r}$) dans laquelle ils sont raccordés de manière orthogonale à la sortie (23) courbe de coupleur (20),
        - une section aval de raccord ($S_{2r}$) dans laquelle ils sont raccordés de manière orthogonale à l'entrée (41) courbe de combineur (40), et
        - une section centrale de correction ($S_c$), située entre les sections amont et aval de raccord, dans laquelle un indice effectif associé aux modes guidés est adapté de sorte que les chemins optiques des guides d'onde intermédiaires (30) entre la sortie (23) courbe du coupleur (20) et l'entrée (41) courbe du combineur (40) sont identiques entre eux.

2. Système optoélectronique selon la revendication 1, dans lequel les guides d'onde intermédiaires (30) présentent, dans la section centrale de correction ($S_c$), une variation longitudinale d'au moins une dimension transversale, ladite variation longitudinale étant prédéfinie pour chaque guide d'onde intermédiaire (30), de sorte que les chemins optiques des guides d'onde intermédiaires (30) sont identiques entre eux.

3. Système optoélectronique selon la revendication 2, dans lequel chaque guide d'onde intermédiaire (30) présente, dans la section centrale de correction ($S_c$), une variation adiabatique de la largeur, passant d'une première valeur minimale ($w_{1r}$) identique pour chaque guide d'onde intermédiaire (30) à une valeur maximale ($w_{c,max}$) différente d'un guide d'onde intermédiaire à l'autre, pour ensuite diminuer jusqu'à une deuxième valeur minimale ($w_{2r}$) identique pour chaque guide d'onde intermédiaire (30).

4. Système optoélectronique selon l'une quelconque des revendications 1 à 3, comportant des guides d'onde dits additionnels (31) réalisés en un indice de réfraction différent de celui des guides d'onde intermédiaires (30), s'étendant uniquement dans la section centrale de correction ($S_c$), et agencés chacun en regard et de manière parallèle à un guide d'onde intermédiaire (30), de manière à autoriser un couplage modal avec le guide d'onde intermédiaire (30) considéré, les guides d'onde additionnels (31) présentant une longueur ($L_{sm(i)}$) prédéfinie différente d'un guide d'onde additionnel (31) à l'autre, de sorte que les chemins optiques des guides d'onde intermédiaires (30) sont identiques entre eux.

5. Système optoélectronique selon l'une quelconque des revendications 1 à 4, comportant des déphaseurs thermo-optiques (32) agencés uniquement dans la section centrale de correction ($S_c$) pour générer, par l'application d'une température aux guides d'onde intermédiaires (30), un déphasage prédéfini entre les modes optiques dans les guides d'onde intermédiaires (30) de sorte que les chemins optiques des guides d'onde intermédiaires (30) sont identiques entre eux.

6. Système optoélectronique selon l'une quelconque des revendications 1 à 5, comportant des portions (34) d'un matériau à changement de phase, situées dans la section centrale de correction ($S_c$), et associées chacune à chaque guide d'onde intermédiaire (30), qui participent à former une gaine de ce dernier, les portions (34) de matériaux à changement de phase appliquant un déphasage relatif, de manière statique ou dynamique, entre les modes guidés dans les guides d'onde intermédiaires (30), prédéfini pour chacun d'entre eux de sorte que les chemins optiques ($C_{(i)}$) des guides d'onde intermédiaires (30) sont identiques entre eux.

7. Système optoélectronique selon l'une quelconque des revendications 1 à 6, dans lequel le coupleur (20) est formé d'un réseau de guides d'onde en pointe (22), chacun étant rectiligne et orienté en direction d'une même position destinée à coïncider avec la position $z_h$, les guides d'onde en pointe (22) étant agencés latéralement de sorte que leurs extrémités aval sont disposées en arc de cercle dont le centre est destiné à être situé en la position $z_h$, formant ainsi la sortie (23) courbe du coupleur (20).

8. Système optoélectronique selon l'une quelconque des revendications 1 à 6, dans lequel le coupleur (20) est un coupleur en étoile, comportant une face d'entrée (21) destinée à être orientée de manière orthogonale à l'axe optique $\Delta$, une face de sortie (23) courbe, et une région (24) de propagation libre d'indice de réfraction homogène délimitée par les faces d'entrée et de sortie.

9. Système optoélectronique selon l'une quelconque des revendications 1 à 8, dans lequel la puce photonique (2) comporte un substrat de type silicium sur isolant.

10. Système optoélectronique selon l'une quelconque des revendications 1 à 9, les puces émettrice (4) et photonique (2) étant assemblées l'une à l'autre par une couche adhésive (5).

**Patentansprüche**

1. Optoelektronische Anlage, die Folgendes aufweist:

  ○ einen Sendechip (4), der eine aufgeweitete Laserquelle (10), die entlang einer optischen Achse $\Delta$ verläuft, einen geraden Monomodus-Abschnitt (12), und einen aufgeweiteten Abschnitt (13) in einer Hauptebene aufweist und mit einer Sendefläche (14) des optischen Signals endet, und so eingerichtet ist, dass er ein optisches Signal aussendet, dessen Wellenfront in der Parallelebene kreisförmig und in einer Position $z_h$, die sich im aufge-weiteten Abschnitt (13) auf der optischen Achse $\Delta$ befindet, zentriert ist;
  ○ einen Photonenchip (2), der eine Kopplungsvorrichtung (1) aufweist, die geeignet ist, die optische Kopplung zwischen einer aufgeweiteten Laserquelle (10) und einem Ausgangswellenleiter (3) auf dem Photonenchip (2) sicherzustellen,
  ○ wobei die aufgeweitete Laserquelle (10), die entlang einer optischen Achse $\Delta$ verläuft, einen geraden Monomodus-Abschnitt (12) und einen aufgeweiteten Abschnitt (13) in einer Hauptebene aufweist, der mit einer Sendefläche (14) des optischen Signals endet und so eingerichtet ist, dass er ein optisches Signal aussendet, dessen Wellenfront in der Hauptebene kreisförmig ist und in einer Position $z_h$ zentriert ist, die sich im aufgeweiteten Abschnitt (13) auf der optischen Achse $\Delta$ befindet;
  ○ wobei die Kopplungsvorrichtung (1) einen auf dem Photonenchip (2) angeordneten Koppler (20), der mit der aufgeweiteten Laserquelle (10) gekoppelt ist, um mindestens einen Teil des gesendeten optischen Signals zu sammeln und zu übertragen, und eine Schaltwaltze (40) aufweist,
  ○ wobei das optoelektronische System ferner so definiert ist, dass:

    ○ der Koppler (20) einen kreisbogenförmig gebogenen Ausgang (23) aufweist, dessen Mitte sich in der

Position $z_h$ befindet;

◦ die Schaltwalze (40)

• mit einem Array von Zwischenwellenleitern (30) gekoppelt ist, um die von diesen übertragenen optischen Signale zu empfangen und sie auf einen Eingang des Ausgangswellenleiters (3) zu fokussieren; und

• eine planare Fokussierlinse ist, die einen Eingang (41) und einen Ausgang (43) aufweist, die einen Bereich (42) mit freier Ausbreitung eines homogenen Brechungsindex begrenzen, wobei der Eingang (41) kreisbogenförmig gebogen ist, dessen Mittelpunkt sich an einer Position $z_{gs}$ der Ausgangsfläche (43) befindet, wo sich der Eingang des Ausgangswellenleiters (3) befindet;

◦ das Zwischenwellenleiternetz (30)

• mit dem gebogenen Ausgang (23) des Kopplers (20) gekoppelt ist, um das gesammelte optische Signal zu empfangen und es bis zum gebogenen Eingang (41) der Schaltwalze (40) zu übertragen; und

• weist Folgendes auf:

- einen vorgeschalteten Anschlussabschnitt ($S_{1r}$), in dem sie orthogonal mit dem gebogenen Ausgang (23) des Kpplers (20) verbunden sind,

- einen nachgeschalteten Anschlussabschnitt ($S_{2r}$), in dem sie orthogonal mit dem gebogenen Eingang (41) der Schaltwalze (40) verbunden sind, und

- einen mittleren Korrekturabschnitt ($S_c$), der sich zwischen den vor- und nachgeschalteten Anschlussabschnitten befindet, wobei ein mit den geführten Modi verbundener effektiver Index so angepasst ist, dass die optischen Pfade der Zwischenwellenleiter (30) zwischen dem gebogenen Ausgang (23) der Kopplers (20) und dem gebogenen Eingang (41) der Schaltwalze (40) untereinander identisch sind.

2. Optoelektronisches System nach Anspruch 1, wobei die Zwischenwellenleiter (30) im mittleren Korrekturabschnitt ($S_c$) eine Längsänderung um mindestens eine Querdimension enthalten, wobei die Längsänderung für jeden Zwischenwellenleiter (30) vordefiniert ist, so dass die optischen Pfade der Zwischenwellenleiter (30) untereinander identisch sind.

3. Optoelektronisches System nach Anspruch 2, wobei jeder Zwischenwellenleiter (30) im mittleren Korrekturabschnitt ($S_c$) eine adiabatische Änderung der Breite enthält, die von einem für jeden Zwischenwellenleiter (30) identischen ersten Mindestwert ($w_{1r}$) zu einem von einem Zwischenwellenleiter zu einem anderen unterschiedlichen Maximalwert ($w_{c,max}$) übergeht, um dann auf einen für jeden Zwischenwellenleiter (30) identischen zweiten Mindestwert ($w_{2r}$) zu sinken.

4. Optoelektronisches System nach einem der Ansprüche 1 bis 3, das zusätzliche Wellenleiter (31) aufweist, die in einem anderen Brechungsindex als der der Zwischenwellenleiter (30) ausgeführt sind, sich nur im mittleren Korrekturabschnitt ($S_c$) erstrecken und jeweils gegenüber und parallel zu einem Zwischenwellenleiter (30) angeordnet sind, um eine modale Kopplung mit dem betrachteten Zwischenwellenleiter (30) zu ermöglichen, wobei die zusätzlichen Wellenleiter (31) mit einer Länge ($L_{sm(i)}$) von einem zusätzlichen Wellenleiter (31) zum anderen vordefiniert ist, so dass die optischen Pfade der dazwischenliegenden Wellenleiter (30) untereinander identisch sind.

5. Optoelektronisches System nach einem der Ansprüche 1 bis 4, das thermooptische Phasenverschieber (32) aufweist, die nur in dem mittleren Korrekturabschnitt ($S_c$) angeordnet sind, um durch Anlegen einer Temperatur an die Zwischenwellenleiter (30) eine vordefinierte Phasenverschiebung zwischen den optischen Modi in den Zwischenwellenleitern (30) zu erzeugen, so dass die optischen Pfade der Zwischenwellenleiter (30) untereinander identisch sind.

6. Optoelektronisches System nach einem der Ansprüche 1 bis 5, das Abschnitte (34) aus einem phasenveränderlichen Material aufweist, die sich im zentralen Korrekturabschnitt ($S_c$) befinden und jeweils mit jedem Zwischenwellenleiter (30) verbunden sind, die daran beteiligt sind, eine Hülle davon zu bilden, wobei die Abschnitte (34) aus phasenveränderlichen Materialien eine relative Phasenverschiebung statisch oder dynamisch zwischen den in den Zwischenwellenleitern (30) geführten Modi anwenden, vordefiniert für jeden unter ihnen, so dass die optischen Pfade ($C_{(i)}$) der Zwischenwellenleiter (30) untereinander identisch sind.

7.  Optoelektronisches System nach einem der Ansprüche 1 bis 6, wobei der Koppler (20) aus einem Netz von spitzen Wellenleitern (22) gebildet ist, wobei jeder gerade und in Richtung einer gleichen Position ausgerichtet ist, die mit der Position $z_h$ übereinstimmen soll, wobei die spitzen Wellenleiter (22) seitlich angeordnet sind, sodass ihre nachgelagerten Enden in einem Kreisbogen angeordnet sind, dessen Mittelpunkt in der Position $z_h$ liegen soll, wodurch der gebogene Ausgang (23) der Kupplung (20) gebildet wird.

8.  Optoelektronisches System nach einem der Ansprüche 1 bis 6, wobei der Koppler (20) ein Sternkoppler ist, der eine Eingangsseite (21), die orthogonal zu der optischen Achse ausgerichtet sein soll Δ, eine gekrümmte Ausgangsseite (23) und einen von den Eingangs- und Ausgangsseiten begrenzten freien Bereich (24) mit homogenem Brechungsindex aufweist.

9.  Optoelektronisches System nach einem der Ansprüche 1 bis 8, wobei der Photonenchip (2) ein Substrat vom Typ Silizium auf Isolator aufweist.

10. Optoelektronisches System nach einem der Ansprüche 1 bis 9, wobei der Sendechip (4) und der Photonenchip (2) durch eine Klebeschicht (5) miteinander verbunden sind.


**Claims**

1.  Optoelectronic system, comprising:

    ○ an emissive chip (4) comprising a flared laser source (10), the laser source comprising, along an optical axis Δ, a straight single-mode section (12), and a section (13) that is flared in a main plane and that ends in an emission surface (14) of the optical signal, and the laser source being configured to emit an optical signal, a wavefront whereof, in the parallel plane, is circular and centred on a position $z_h$ located in the flared section (13) on the optical axis Δ;
    ○ a photonic chip (2) comprising a coupling device (1) adapted to optically couple a flared laser source (10) with an output waveguide (3) on the photonic chip (2),
    ○ the flared laser source (10) comprising, along an optical axis Δ, a straight single-mode section (12), and a section (13) that is flared in a main plane and that ends in an emission surface (14) of the optical signal, and the flared laser source being configured to emit an optical signal, a wavefront whereof, in the main plane, is circular and centred on a position $z_h$, located in the flared section (13) on the optical axis Δ;
    ○ the coupling device (1) comprising, disposed on the photonic chip (2), a coupler (20) coupled to the flared laser source (10) in order to collect and transmit at least part of the emitted optical signal, and a combiner (40),
    ○ the optoelectronic system being further defined in that:

        ○ the coupler (20) comprises a curved output (23) in the shape of an arc of a circle, the centre of which is located at the position $z_h$;
        ○ the combiner (40)

            • is coupled to an array of intermediate waveguides (30) in order to receive the optical signals transmitted thereby, and to focus them onto an input of the output waveguide (3); and
            • is a planar focusing lens comprising an input (41) and an output (43) delimiting a free-propagating region (42) of uniform refractive index, the input (41) being curved in an arc of a circle whose centre is at a position $z_{gs}$ on the output face (43) where the input of the output waveguide (3) is located;

        ○ the array of intermediate waveguides (30)

            • is coupled to the curved output (23) of the coupler (20) in order to receive the collected optical signal and transmit it to the curved input (41) of the combiner (40); and
            • comprises:

                - a upstream connection section ($S_{1r}$) in which the intermediate waveguides are orthogonally connected to the curved output (23) of the coupler (20),
                - a downstream connection section ($S_{2r}$) in which the intermediate waveguides are orthogonally connected to the curved input (41) of the combiner (40), and
                - a central correction section ($S_c$) located between the upstream and downstream connection sections, in which an effective index associated with the guided modes is adapted such that the optical paths of the intermediate waveguides (30) between the curved output (23) of the coupler (20) and the curved input (41) of the combiner (40) are identical to each other.

2. Optoelectronic system according to claim 1, wherein the intermediate waveguides (30) have, in the central correction section ($S_c$), a longitudinal variation of at least one transverse dimension, said longitudinal variation being predefined for each intermediate waveguide (30), such that the optical paths of the intermediate waveguides (30) are identical to each other.

3. Optoelectronic system according to claim 2, wherein each intermediate waveguide (30) has, in the central correction section ($S_c$), an adiabatic variation of the width, passing from a first minimum value ($w_{1r}$) that is identical for each intermediate waveguide (30) to a maximum value ($w_{c,max}$) different from one intermediate waveguide to the next, in order to then to decrease to a second minimum value ($w_{2r}$) that is identical for each intermediate waveguide (30).

4. Optoelectronic system according to any one of claims 1 to 3, comprising so-called additional waveguides (31) made of a refractive index that is different from that of the intermediate waveguides (30), extending solely in the central correction section ($S_c$), and each being arranged facing and parallel to an intermediate waveguide (30), so as to permit modal coupling with the intermediate waveguide (30) considered, the additional waveguides (31) having a predefined length ($L_{sm(i)}$) different from one additional waveguide (31) to the next, such that the optical paths of the intermediate waveguides (30) are identical to each other.

5. Optoelectronic system according to any one of claims 1 to 4, comprising thermo-optic phase shifters (32) arranged solely in the central correction section ($S_c$) in order to generate, by applying a temperature to the intermediate waveguides (30), a predefined phase shift between the optical modes in the intermediate waveguides (30) so that the optical paths of the intermediate waveguides (30) are identical to each other.

6. Optoelectronic system according to any one of claims 1 to 5, comprising portions (34) of a phase-change material, located in the central correction section ($S_c$), and each associated with each intermediate waveguide (30), and which portions participate in forming a cladding therefor, the portions (34) of phase-change materials applying a relative phase shift, statically or dynamically, between the guided modes in the intermediate waveguides (30), which phase shift is predefined for each of the intermediate waveguides so that the optical paths ($C_{(i)}$) of the intermediate waveguides (30) are identical to each other.

7. Optoelectronic system according to any one of claims 1 to 6, wherein the coupler (20) is formed of an array of tapered waveguides (22), each being rectilinear and oriented in the direction of a same position intended to coincide with the position $z_h$, the tapered waveguides (22) being arranged laterally so that their downstream ends are arranged in an arc of a circle whose centre is intended to be located at the position $z_h$, thus forming the curved output (23) of the coupler (20).

8. Optoelectronic system according to any one of claims 1 to 6, wherein the coupler (20) is a star coupler comprising an input face (21) intended to be oriented orthogonally to the optical axis $\Delta$, a curved output face (23), and a free-propagation region (24) of uniform refractive index delimited by the input and output faces.

9. Optoelectronic system according to any one of claims 1 to 8, wherein the photonic chip (2) comprises a silicon-on-insulator substrate.

10. Optoelectronic system according to any one of claims 1 to 9, wherein the emissive chip (4) and the photonic chip (2) are assembled to each other by an adhesive layer (5).

Fig.1

**Fig.2A**

**Fig.2B**

Fig.3A

Fig.3B

**Fig.4**

**Fig.5**

**Fig.6A**

**Fig.6B**

## RÉFÉRENCES CITÉES DANS LA DESCRIPTION

**Documents brevets cités dans la description**

- FR 2821166

**Littérature non-brevet citée dans la description**

- **WENZEL et al.** High-brightness diode lasers. *C.R. Physique*, 2003, vol. 4, 649-661
- How to Launch 1 W Into Single-Mode Fiber from a Single 1.48μm Flared Resonator. *IEEE Journal on Selected Topics in Quantum Electronics*, 2001, vol. 7 (2), 111-123
- **KIM et al.** Luneburg Lens for Wide-Angle Chip-Scale Optical Beam Steering. *Conference on Lasers and Electro-Optics (CLEO)*, 2019
- **ABDOLLAHRAMEZANI et al.** Tunable nanophotonics enabled by chalcogenide phase-change materials. *Nanophotonics*, 2020, vol. 9 (5), 1189-1241